Europäisches Patentamt

European Patent Office

Office européen des brevets

(11) Publication number: **0 127 142**
**B1**

## (12) EUROPEAN PATENT SPECIFICATION

(45) Date of publication of patent specification: **10.08.88**

(21) Application number: **84105944.7**

(22) Date of filing: **24.05.84**

(51) Int. Cl.⁴: **H 01 L 21/76, H 01 L 29/06**

(54) Semiconductor device having at least one field effect transistor.

(30) Priority: **24.05.83 JP 91018/83**

(43) Date of publication of application:
**05.12.84 Bulletin 84/49**

(45) Publication of the grant of the patent:
**10.08.88 Bulletin 88/32**

(84) Designated Contracting States:
**DE FR GB IT**

(56) References cited:
**EP-A-0 067 419**
**EP-A-0 068 154**
**US-A-3 728 161**
**US-A-3 936 858**
**US-A-4 219 379**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Aoki, Takao c/o Patent Division**
**Kabushiki Kaisha Toshiba 1-1 Shibaura 1-chome**
**Minato-ku Tokyo 105 (JP)**

(74) Representative: **Lehn, Werner, Dipl.-Ing. et al**
**Hoffmann, Eitle & Partner Patentanwälte**
**Arabellastrasse 4**
**D-8000 München 81 (DE)**

Courier Press, Leamington Spa, England.

EP 0 127 142 B1

## Description

The present invention relates to a semiconductor device having at least one field effect transistor.

In conventional metal oxide semiconductor field effect transistors (to be referred to as MOS transistors hereinafter), a field oxide film (thick oxide film) is used to isolate elements formed on a single chip. On the other hand, a thin oxide film is formed in element regions (MOS transistor formation portions) or channels of the MOS transistors. Various wiring layers are formed on the field oxide film. It is known that a parasitic MOS transistor is formed such that the wiring pattern is used as the gate electrode and the field oxide film is used as the gate oxide film when voltages at these wiring layers become high enough to weakly or completely invert the conductivity type of the surface layer (field region) of the semiconductor substrate under the field oxide film. In order to prevent conductivity inversion of the surface of the field region in the semiconductor substrate, the impurity concentration of the surface layer of the field region is increased. For example, as described in IEDM Technical Digest 1975, pp. 573—576, and IEDM Technical Digest 1980, pp. 724—727, "a technique is known wherein a high impurity layer (surface layer, field doping or field stopper) having the same conductivity type as that of the semiconductor substrate is formed in the field region.

A conventional semiconductor device having the surface layer described above is prepared as follows, exemplified by a p-channel silicon gate MOS transistor. As shown in Fig. 1, a photoresist film 13 is formed on a semiconductor substrate 11. Subsequently, as shown in Fig. 2, the photoresist film 13 is etched by conventional photoengraving process to form openings which correspond to prospective field regions (element isolation regions). Ion implantation is performed by using residual photoresist films 13a, 13b and 13c, so that $n^+$-type layers 15a, 15b and 15c are formed in prospective field regions, as shown in Fig. 3. Each of the $n^+$-type layers 15a, 15b and 15c have a high impurity concentration and correspond to the surface layer described above. The residual photoresist films 13a, 13b and 13c are removed, and an oxide film 17 is deposited by the CVD method to cover the entire surface, as shown in Fig. 4. The oxide film 17 is selectively etched by photoengraving process to form field oxide films 19a, 19b and 19c, as shown in Fig. 5. The resultant structure is exposed to an oxygen atmosphere at a high temperature (e.g., 1,000°C) to grow thin oxide films 21a, 21b and 21c on the $n^+$-type layers 15a, 15b and 15c, respectively, as shown in Fig. 6. In this case, the n-type impurity diffuses from the $n^+$-type layers 15a, 15b and 15c into the substrate 11, so that the $n^+$-type layers 15a, 15b and 15c extend into field regions. Subsequently, a polysilicon (poly-Si) layer is formed by the CVD method to cover the entire exposed surface portions of the oxide films 19a, 21a, 19b, 21b, 19c, and 21c. The poly-Si layer is patterned to obtain poly-Si electrodes 23 and 25 at predetermined positions, as shown in Fig. 7. As shown in Fig. 8, a $p^+$-type layer 27 serving as a diffusion wiring layer and a $p^+$-type layer 29 serving as a source or drain are formed by ion implantation. As shown in Fig. 9, an insulating film 31 is formed to cover the exposed surface of the resultant structure. Finally, an aluminum wiring layer 33 and a passivation film 35 are sequentially formed to prepare a poly-Si gate MOSIC as shown in Fig. 10.

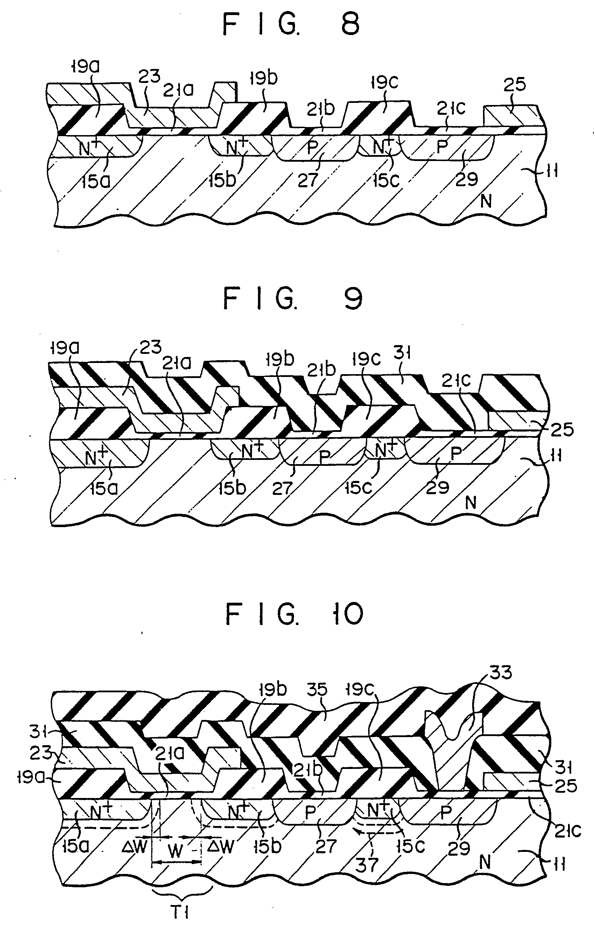

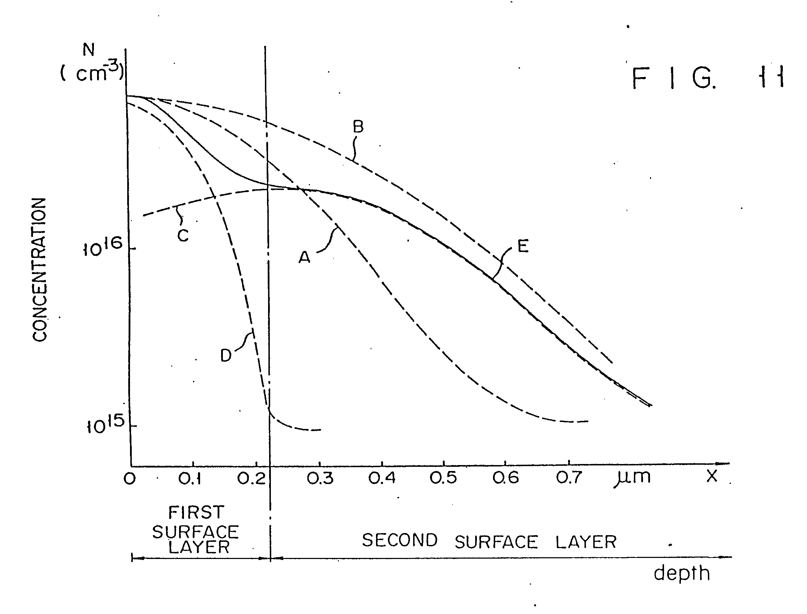

The impurity concentration profile of the surface layers 15a to 15c of the conventional semiconductor device is represented by curves A and B in Fig. 11. In the curves A and B, the surface concentration is set to be a predetermined value, and an internal concentration profile is varied in accordance with changes in the conditions of ion implantation and annealing. It should be noted that the impurity concentration in the semiconductor substrate is about $10^{15}$ cm$^{-3}$. If the impurity distribution profile of the surface layers 15a—15c is set in accordance with the curve A, the surface layers 15a—15c become relatively shallow. In this case, a punch-through phenomenon occurs, for example, between the $p^+$-type diffusion layers 27 and 29, and a current path (channel) is formed under the surface layer 15c, as indicated by a dotted arrow 37 in Fig. 10. This drawback typically occurs when the surface layers 15a—15c are shallower than the $p^+$-type layers 27 and 29. On the other hand, the packing density of semiconductor devices has recently been increased. Along with this development of highly integrated semiconductor devices, the elements can now be micropatterned and the element isolation region between the element regions has become narrower. For these reasons, it is thus expected that the punch-through phenomenon will occur between the sources and drains of the parasitic MOS transistors more frequently.

In order to prevent the punch-through phenomenon, the impurity concentration profile of the surface layers 15a—15c is given in accordance with the curve B in Fig. 11. In other words, the surface layers 15a—15c are formed deeply. However, when the impurity concentration of the surface layers 15a—15c becomes high, diffusion and leakage of the impurity from the surface layers 15a—15c cannot be neglected, for example, as described in "IEDM Technical Digest 1975, pp. 573—576" and "IDEM Technical Digest 1980 pp. 724—727". Assume that the surface layers 15a—15c are expanded, as indicated by the dotted line in Fig. 10, due to the diffusion and leakage of the impurity from the surface layers 15a—15c. In this case, the effective gate width of the gate region represented by T1 in Fig. 10 is decreased from the normal value W to (W−2$\Delta$W). This decrease in gate width increases the threshold voltage of the MOS transistor, thereby decreasing the transconductance gm. In addition, along with the development of highly integrated semiconductor devices, as previously described, the gate width has become narrower. For this reason, the decrease in gate width due to the diffusion and leakage of the impurity presents a critical drawback. In addition, when the impurity concentration of the surface layers 15a—15c in the semiconductor substrate 11 is increased, the junction capacitance between the surface layers 15a—15c and the p-type diffusion layers 27 or 29 is also increased. As a result, the operating speed is lowered, thereby prohibiting a high speed operation and a highly packed density.

The surface layer must satisfy at least three conditions as follows:

(1) The surface layer must have a high impurity concentration in the vicinity of the substrate surface·so as to prevent inversion of the conductivity type of the substrate surface.

(2) The surface layer must have a sufficient depth and a sufficient impurity concentration so as to prevent the punch-through phenomenon.

(3) The surface layer must be free from the diffusion and leakage of an impurity to the element region, especially to the gate region of the MOS transistor.

However, the conventional surface layer does not satisfy the three conditions described above.

The present invention has been made in consideration of the above situation, and has as its object to provide a semiconductor device wherein an influence of a parasitic MOS transistor can be reduced, element isolation is completely performed, and a field effect transistor having predetermined electrical characteristics can . be formed.

In order to achieve the above object of the present invention, there is provided a semiconductor device having:

a semiconductor body of a first conductivity type;

an element region formed in said semiconductor body and provided with at least one field effect transistor;

a field region formed in said semiconductor body, defining said element region, and provided with at least one field insulating film; and

a high-impurity surface layer of the first conductivity type which is formed in a predetermined region of said field region,

characterised in that

said high-impurity surface layer comprises:

a first layer of the first conductivity type which is formed largely under said field insulating film, and has a high impurity concentration and a peak thereof in a vicinity of a surface of said semiconductor body, the impurity concentration decreasing abruptly in accordance with an increase in depth and said first layer being formed in substantially an entire area of said field region; and

a second layer of the first conductivity type which is formed on a surface of said first layer, said second layer being adjacent to said semiconductor body and formed in substantially an entire area of said field region, said second layer having a higher impurity concentration than that of said semiconductor body and a lower impurity concentration than that of said first layer, the impurity concentration decreasing with increase of depth more slowly than in said first layer.

According to the semiconductor device having the structure described above, the punch-through phenomenon between parasitic MOS transistors can be prevented by the second layer. Therefore, the respective MOS transistors can be electrically isolated from each other. On the other hand, the first layer has a high impurity concentration and has an impurity concentration peak in the vicinity of the substrate surface. For this reason, inversion of the conductivity type of the semiconductor substrate surface, which is caused by the voltage in the wiring layer on the field oxide film, can be prevented, and the threshold voltages of the parasitic MOS transistors can be increased. In addition, the first layer has a shallow depth and has an impurity concentration peak in the vicinity of the semiconductor surface. For this reason, diffusion and leakage of the impurity to the element region, especially to the gate region of the MOS transistor, is small. As a result, the electrical characteristics of the MOS transistor are free from deviation. According to the present invention, there is provided a semiconductor device which has a high threshold voltage of the parasitic MOS transistors, is free from the punch-through phenomenon·between the parasitic MOS transistors, provides complete element isolation, is free from deviations in the electrical characteristics of the MOS transistor formed in the element region, and is suitable for high packing density.

This invention can be more fully understood from the following detailed description when taken in conjunction with the accompanying drawings, in which:

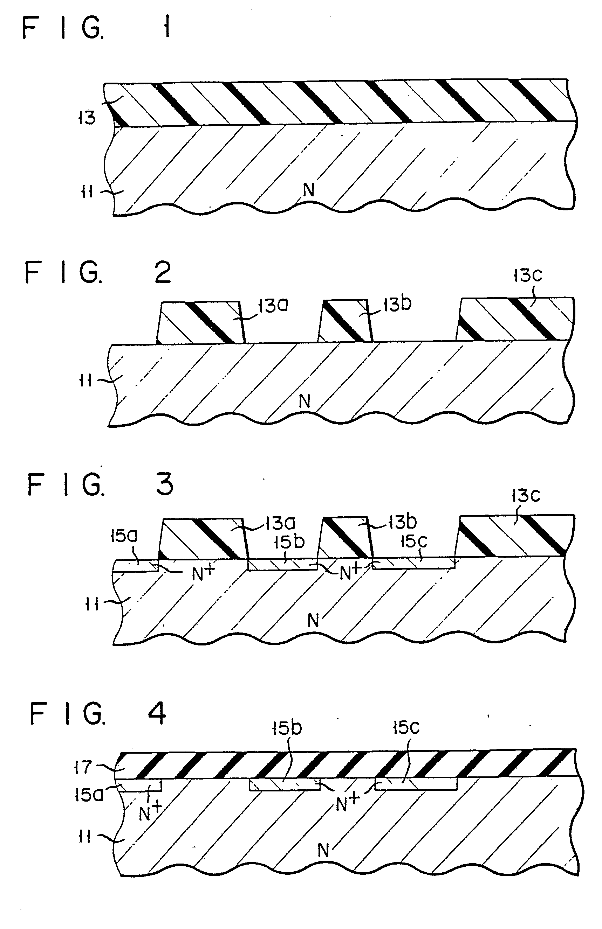

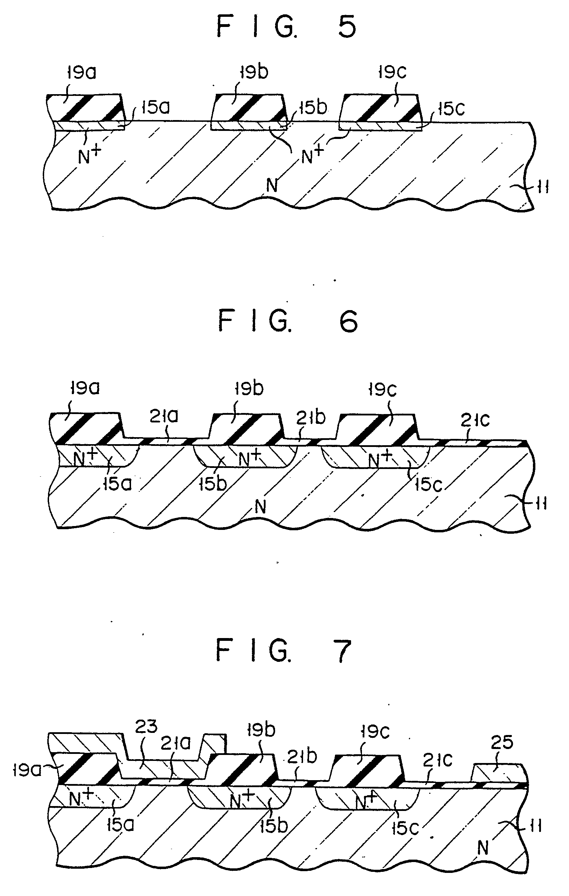

Figs. 1 to 9 are sectional views for explaining the steps in manufacturing a conventional semiconductor device;

Fig. 10 is a sectional view of the conventional semiconductor device;

Fig. 11 is a graph for explaining the impurity concentration as a function of the depth from the surface of the field region of both the conventional semiconductor device and a semiconductor device of the present invention;

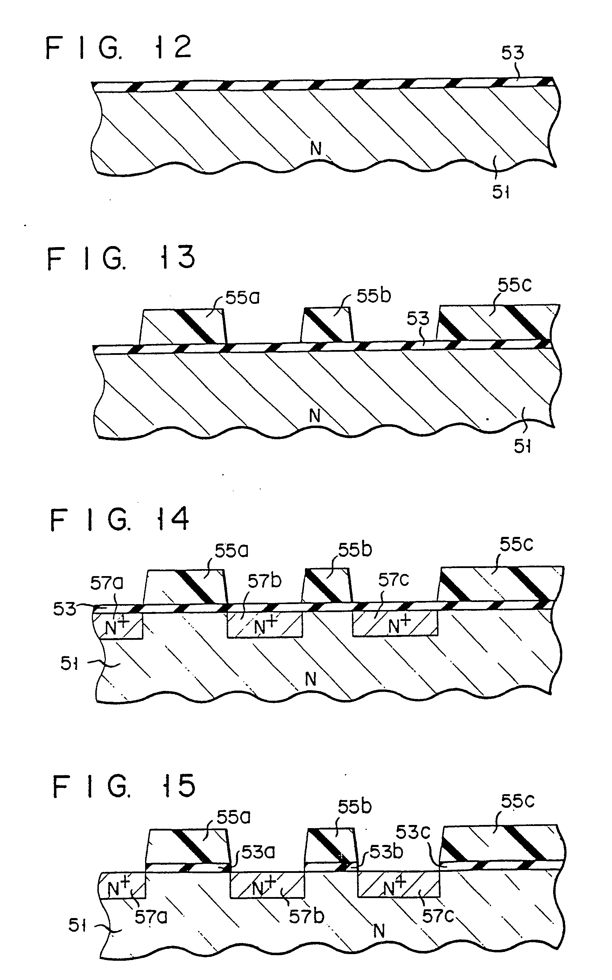

Figs. 12 to 21 are sectional views for explaining the respective steps in manufacturing a semiconductor device according to an embodiment of the present invention;

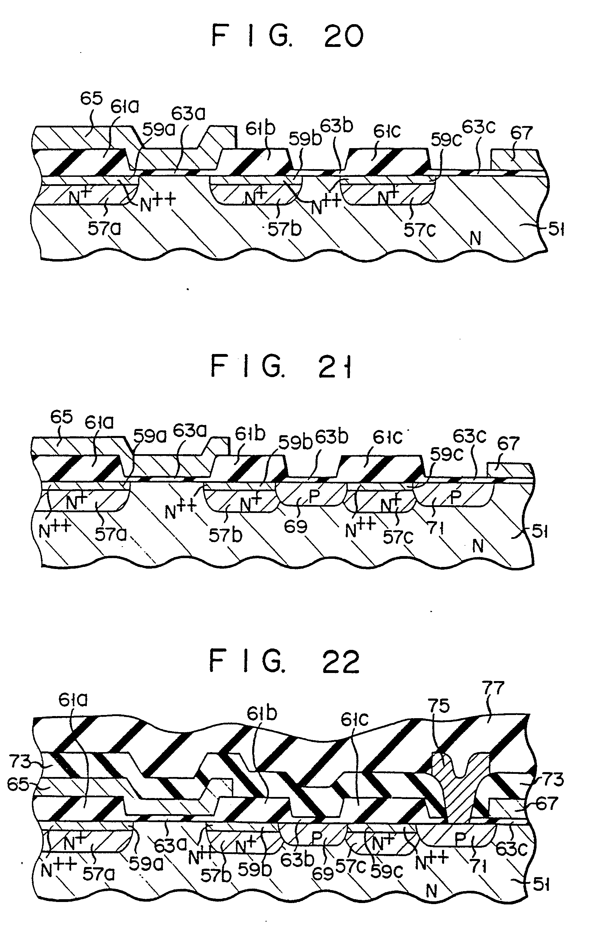

Fig. 22 is a sectional view of the semiconductor device according to an embodiment of the present invention; and

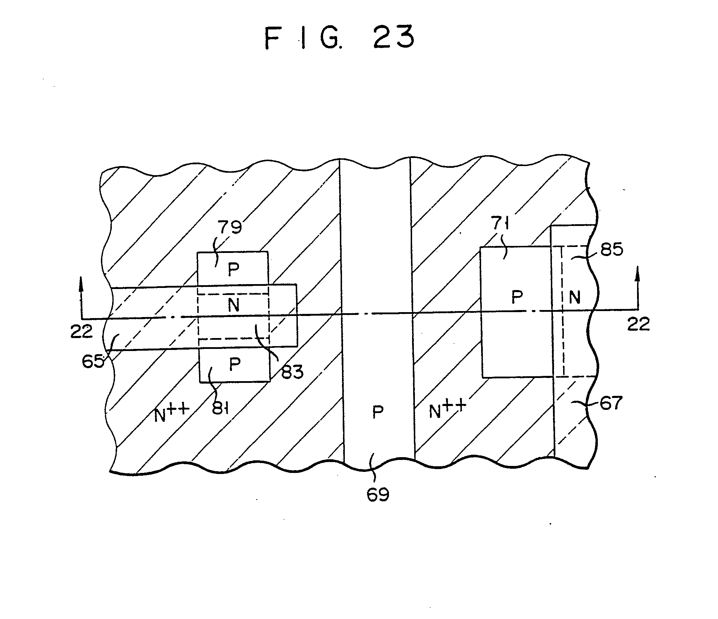

Fig. 23 is a front view of the semiconductor device shown in Fig. 22.

A semiconductor device according to an embodiment of the present invention will now be described with reference to the manufacturing steps shown in Figs. 12 to 23.

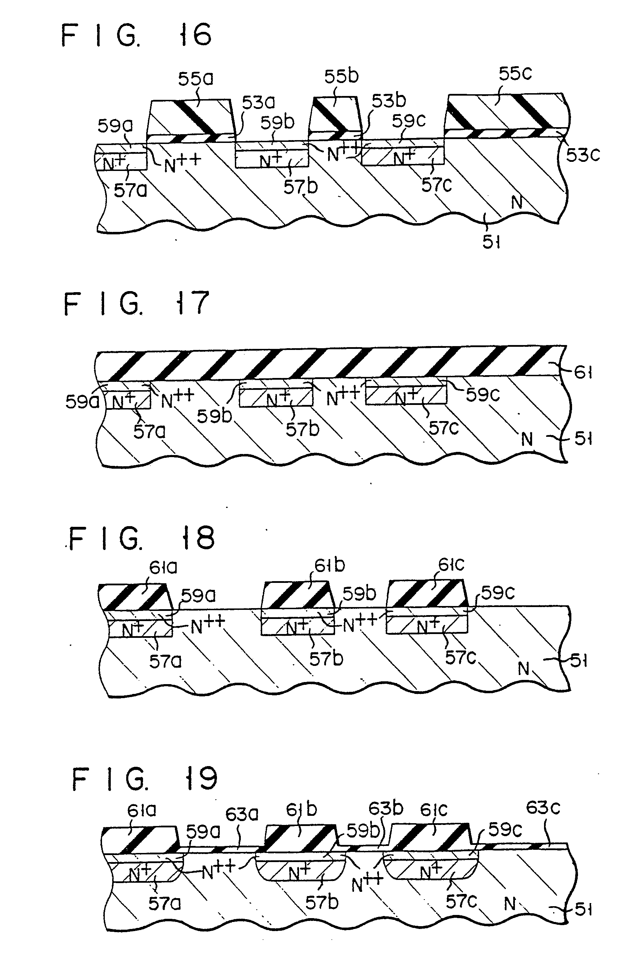

Referring to Fig. 12, a silicon oxide film 53 is formed on an n-type silicon substrate 51, for example, to a thickness of about 90 nm. A photoresist film is formed to cover the silicon oxide film 53. As shown in Fig. 13, portions of the photoresist film which correspond to the field regions (element isolation regions) are removed by photoengraving process to leave residual photoresist portions 55a, 55b and 55c. First ion implantation is deeply performed to dope an n-type impurity into the semiconductor substrate 51, thereby forming second surface layers 57a, 57b and 57c for preventing the punch-through phenomenon, as shown in Fig. 14. The acceleration energy for the first ion implantation is set such that the doped n-type impurity is injected into the semiconductor substrate 51 through the silicon oxide film 53, but the impurity will not pass through the residual photoresist portions 55a, 55b and 55c. For this purpose, $^{31}P^+$ (phosphorus) as the impurity is ion-implanted at a dose Q of $1 \times 10^{12}$ cm$^{-2}$ and at an acceleration voltage Vacc of 300 eV. As a result, n$^+$-type second surface layers 57a, 57b and 57c whose impurity concentration is higher than that of the semiconductor substrate 51 are formed. As shown in Fig. 15, the portions of silicon oxide film 53 which are located on the field regions are removed. In this case, residual silicon oxide films 53a, 53b and 53c are left under the residual photoresist portions 55a, 55b and 55c. Subsequently, in order to prevent conductivity type inversion of the semiconductor substrate surface, second ion implantation is performed, wherein an n-type impurity is ion-implanted in the semiconductor substrate 51. The second ion implantation is performed to form the high impurity regions (first surface layer) having a shallow depth and the impurity concentration peak is located in the vicinity of the substrate surface. In practice, $^{75}As^+$ (arsenic) as the n-type impurity is ion-implanted at a dose Q of $6 \times 10^{11}$ cm$^{-2}$ and at an acceleration voltage Vacc of 40 keV. N$^{++}$-type first surface layers 59a, 59b and 59c are formed to overlay the second surface layers 57a, 57b and 57c, respectively, as shown in Fig. 16. The first surface layers 59a, 59b and 59c have a higher impurity concentration than that of the second surface layers 57a, 57b and 57c and have concentration peaks in the vicinity of the surface of the semiconductor substrate 51. The residual silicon oxide films 53a to 53c and the residual photoresist portions 55a to 55c are removed. Thereafter, an oxide film 61 is formed, for example, by the CVD method to cover the exposed surface of the resultant structure to a thickness of 0.5 μm, as shown in Fig. 17. The oxide film 61 is etched by the photoengraving process to respectively form field oxide films (61a, 61b and 61c on the field regions (on the first surface layers) 59a, 59b and 59c, as shown in Fig. 18. Thin oxide films 63a, 63b and 63c are grown, as shown in Fig. 19. (They are used as gate oxide films). At this time, impurity diffuses from the second and first surface layers 57a to 57c and 59a to 59c. Consequently, the second surface layers 57a, 57b and 57c become deeper than the p-type region serving as the source or drain of the MOS transistor described later. A boron-doped poly-Si film is formed on the oxide films 61a to 61c and 63a to 63c. The poly-Si film is patterned to form poly-Si electrodes 65 and 67, as shown in Fig. 20. The poly-Si electrodes 65, 67 serve as wiring layers (interconnecting layers) and gate electrodes. P$^+$-type layers 69 and 71 serving as a source or drain, and diffusion wiring are formed, as shown in Fig. 21. These layers can be formed by ion implantation or thermal diffusion. Annealing is then performed to activate and diffuse the doped impurity for ion implantation. Subsequently, an insulating film 73 of about 1 μm thickness is formed. In addition, an aluminum wiring pattern 75 and a passivation film 77 are sequentially formed to prepare the semiconductor device shown in Fig. 22. Fig. 23 is a plan view of the semiconductor device shown in Fig. 22. For convenience, only the positional relationship between the layers formed in the semiconductor substrate 51 and the silicon electrodes 65 and 67 is illustrated. Fig. 22 is a sectional view of the semiconductor device taken along the line 22—22 of Fig. 23. Referring to Fig. 23, one transistor is constituted by p-type regions 79 and 81 and an n-type region 83, and the other transistor is constituted by a p-type region 71 and an n-type region 85, and another p-type region (not shown). The hatched portions correspond to the first surface layers which extend over the entire area of the field regions.

Fig. 11 is a graph comparing the n-type impurity concentration profiles of the first and second surface layers of the semiconductor device prepared by the steps of Figs. 12 to 22. A curve C indicates the concentration profile of the n-type impurity doped in the first ion implantation as a function of the depth from the surface of the substrate 51. On the other hand, a curve D indicates an impurity concentration profile of the n-type impurity doped in the second ion implantation as a function of the depth from the surface of the substrate 51. In practice, a layer having an impurity concentration indicated by a curve E as a composite curve of the curves C and D is formed in a portion of the semiconductor substrate 51 which is located under the field oxide films 61a to 61c. Impurity concentrations indicated by the curves A, B and E are set to be equal to one another at the surface of the semiconductor substrate. As indicated by the curve E in Fig. 11, the impurity concentration of the field region is set such that a portion in the vicinity of the surface of the semiconductor substrate 51 is high, and the impurity concentration abruptly decreases in accordance with an increase in depth X. When the depth X is increased, a deep portion is free from the influence of the second ion implantation and has substantially the same impurity concentration profile as that of the surface layer of the conventional semiconductor device.

As indicated by the curve E in Fig. 11, the second surface layers 57a to 57c are formed deeper than the p-type layer 69 or 71 of the MOS transistor. The second surface layers 57a to 57c have an impurity concentration high enough to prevent the punch-through phenomenon. For this reason, the punch-through phenomenon between the parasitic MOS transistors can be completely prevented. In addition, the first surface layers 59a to 59c which have a sufficiently high concentration especially in the vicinity of the surface of the semiconductor substrate 51, prevent the inversion of the conductivity type of the semiconductor substrate. So even if voltages in the wiring layers 65 on the field oxide films 61a to 61c receive a high voltage, the conductivity type of the semiconductor substrate is not inverted. As a result, the threshold voltage of the parasitic MOS transistor can be kept sufficiently high. Furthermore, the impurity concentration profile of the first surface layers 59a to 59c is provided such that the impurity of the concentration is abruptly decreased upon an increase in depth X. Therefore, diffusion and leakage of the impurity from the first surface layers 59a to 59c to the element region and especially to the gate region of the MOS transistor does not occur. In addition to this advantage, the junction capacitances between the first surface layers 59a to 59c and the p-type regions of the MOS transistors or diffusion wiring layers can be decreased.

According to the present invention as described above, the threshold voltages of the parasitic MOS transistors are sufficiently high, and the diffusion and leakage of the impurity to the gate region (active region) of the MOS transistor element are small, thereby providing effective isolation of the elements.

In the above embodiment, the second surface layers 57a to 57c are formed to be deeper than the p-type regions 69 to 71 of the MOS transistor which serves as the source or drain, and the diffusion wiring 69. However, the present invention is not limited to this arrangement. The depth of each second surface layer can be selected within the range which prevents the punch-through phenomenon.

Furthermore, in the above embodiment, the first and second surface layers are formed in the entire surface of the field regions (except in the element regions, the diffusion wiring and the contact portions between the wiring layers and the substrate). However, the present invention is not limited to this construction. Provided that the wiring layers are formed on the field oxide film and the punch-through phenomenon does not occur, the first and second surface layers may be formed below the wiring layers, i.e., in only those portions of the semiconductor substrate which may be subjected to conductivity type inversion of the semiconductor substrate surface. For example, referring to Fig. 22, the first and second surface layers 59a and 57a may be formed under only the gate electrode 65.

In the above embodiment, the MOS transistors are formed on the n-type semiconductor substrate 51. However, the present invention is not limited to this arrangement. For example, an n-type well region may be formed in a p-type semiconductor substrate, and a MOS transistor may be formed in the well region. Alternatively, a MOS transistor may be formed in an n-type semiconductor layer formed on a p-type semiconductor substrate.

In the above embodiment, the second ion implantation process for forming the first surface layers is performed after the silicon oxide film 53 is removed. However, the present invention is not limited to this sequence. For example, ion implantation may be performed through the silicon oxide film 53 by increasing the acceleration voltage.

Furthermore, in the above embodiment, P (phosphorus) is used in the first ion implantation process, and As (arsenic) is used in the second ion implantation process. However, the type of impurity is not limited to these, and a predetermined concentration profiled can be obtained with other impurities.

Furthermore, in the above embodiment, the field oxide films 61a to 61c and the gate oxide films 63a to 63c are formed on the semiconductor substrate 51. However, the field and gate insulation films are not limited to oxide films. Conventional insulating films may also be used for this purpose.

In the above embodiment, the p-channel MOS transistor is formed in an n-type semiconductor substrate. However, the present invention is not limited to the manufacture of a p-channel MOS transistor in an n-type semiconductor substrate. For example, an n-channel MOS transistor may be formed in a p-type semiconductor substrate to obtain the same effect as in the above embodiment.

In the above embodiment, one MOS transistor is formed in one element region. However, the present invention is not limited to this one-to-one correspondence, and a plurality of MOS transistors may be formed in one element region.

## Claims

1. A semiconductor device having:
a semiconductor body (51) of a first conductivity type;
an element region formed in said semiconductor body and provided with at least one field effect transistor;
a field region formed in said semiconductor body, defining said element region, and provided with at least one field insulating film (61a, 61b, 61c); and
a high-impurity surface layer of the first conductivity type which is formed in a predetermined region of said field region,
characterised in that
said high-impurity surface layer comprises:
a first layer (59a, 59b, 59c) of the first conductivity type which is formed largely under said field insulating film, and has a high impurity concentration and a peak thereof in the vicinity of a surface of said semiconductor body, the impurity concentration decreasing abruptly in accordance with an increase in depth and said first layer being formed in substantially the entire area of said field region; and

a second layer (57a, 57b, 57c) of the first conductivity type which is formed on a surface of said first layer, said second layer being adjacent to said semiconductor body and formed in substantially the entire area of said field region, said second layer (57a, 57b, 57c) having a higher impurity concentration than that of said semiconductor body (51) and a lower impurity concentration than that of said first layer (59a, 59b, 59c), the impurity concentration decreasing with increase of depth more slowly than in said first layer.

2. A semiconductor device according to claim 1, characterised in that said second layer (57a, 57b, 57c) is more deeply formed from a surface of said semiconductor body than at least one second conductivity type region (71) which is formed in said element region and which constitutes said at least one field effect transistor.

3. A semiconductor device according to claims 1 and 2, characterised in that said first layer (59a, 59b, 59c) and second layer (57a, 57b, 57c) are formed by different ion implantation steps, respectively.

4. A semiconductor device according to claims 1 to 3, characterised in that the impurity concentration of said first layer (59a, 59b, 59c) is between about $8.0 \times 10^{16}$ cm$^{-3}$ and about $2.2 \times 10^{16}$ cm$^{-3}$ and that of said second layer (57a, 57b, 57c) is no greater than about $2.2 \times 10^{16}$ cm$^{-3}$.

**Patentansprüche**

1. Halbleiteranordnung mit einem Halbleiterkörper (51) eines ersten Leitfähigkeitstyps;

einem im Halbleiterkörper ausgebildeten und mit wenigstens einem Feldeffekttransistor versehenen Elementbereich;

einem im Halbleiterkörper ausgebildeten und mit wenigstens einem feldisolierenden Film (61a, 61b, 61c) versehenen Feldbereich, der den Elementbereich definiert; und

einer Oberflächenschicht des ersten Leitfähigkeitstyps mit einer hohen Störstoffkonzentration, die in einem vorbestimmten Bereich des Feldbereichs ausgebildet ist,

dadurch gekennzeichnet, daß

die Oberflächenschicht mit einer hohe Störstoffkonzentration enthält:

eine erste Schicht (59a, 59b, 59c) des ersten Leitfähigkeitstyps, die im wesentlich unter dem feldisolierenden Film ausgebildet ist und eine hohe Störstoffkonzentration und einen Höchstwert derselben in der Nähe einer Oberfläche des Halbleiterkörpers aufweist, wobei sich die Störstoffkonzentration mit zunehmender Tiefe sprunghaft verringert und wobei die erste Schicht im wesentlichen auf der gesamten Fläche des Feldbereichs ausgebildet ist; und

eine zweite Schicht (57a, 57b, 57c) des ersten Leitfähigkeitstyps, die auf einer Oberfläche der ersten Schicht ausgebildet ist, wobei die zweite Schicht an den Halbleiterkörper angrenzt und im wesentlichen auf der gesamten Fläche des Feldbereichs ausgebildet ist, wobei die zweite Schicht (57a, 57b, 57c) eine höhere Störstoffkonzentration als die des Halbleiterkörpers (51) und eine niedrigere Störstoffkonzentration als die der ersten Schicht (59a, 59b, 59c) aufweist, wobei sich diese Störstoffkonzentration mit zunehmender Tiefe langsamer verringert als in der ersten Schicht.

2. Halbleiteranordnung nach Anspruch 1, dadurch gekennzeichnet, daß die zweite Schicht (57a, 57b, 57c) tiefer von einer Oberfläche des Halbleiterkörpers aus als wenigstens ein Bereich (71) eines zweiten Leitfähigkeitstyps ausgebildet ist, welcher im Elementbereich ausgebildet ist und welcher den wenigstens einen Feldeffkettransistor bildet.

3. Halbleitervorrichtung nach den Ansprüchen 1 und 2, dadurch gekennzeichnet, daß die erste Schicht (59a, 59b, 59c) und die zweite Schicht (57a, 57b, 57c) durch jeweils verschiedene Ionen-Implantationsschritte ausgebildet sind.

4. Halbleiteranordnung nach den Ansprüchen 1 bis 3, dadurch gekennzeichnet, daß die Störstoffkonzentration der ersten Schicht (59a, 59b, 59c) zwischen etwa $8.0 \times 10^{16}$ cm$^{-3}$ und etwa $2.2 \times 10^{16}$ cm$^{-3}$ liegt und die der zweiten Schicht (57a, 57b, 57c) nicht größer als etwa $2.2 \times 10^{16}$ cm$^{-3}$ ist.

**Revendications**

1. Dispositif à semiconducteurs possédant:

un corps semiconducteur (51) d'un premier type de conductivité

une région d'éléments formée dans ledit corps semiconducteur et dotée d'au moins un transistor à effet de champ;

une région de champ formée dans ledit corps semiconducteur, définissant ladite région d'éléments, et dotée d'au moins une pellicule isolante de champ (61a, 61b, 61c); et

une couche de surface à concentration en impureté élevée du premier type de conductivité, qui est formée dans une région prédéterminée de ladite région de champ,

caractérisé en ce que

ladite couche de surface à concentration en impureté élevée comprend:

une première couche (59a, 59b, 59c) du premier type de conductivité, qui est formée largement au-dessous de ladite pellicule isolante de champ et qui présente une concentration en impureté élevée et une valeur de crête pour cette concentration dans le voisinage de la surface dudit corps semiconducteur, la concentration en impureté diminuant brusquement en fonction de l'augmentation de la profondeur, et ladite première couche étant formée sensiblement sur toute l'aire de ladite région de champ; et

une deuxième couche (57a, 57b, 57c) du premier type de conductivité, qui est formée à la surface de ladite première couche, ladite deuxième couche étant adjacente audit corps conducteur et étant formée sensiblement sur toute l'aire de ladite région de champ, ladite deuxième couche (57a, 57b, 57c) possédant une concentration, en impureté plus élevée que ledit corps semiconducteur (51) et une concentration en impureté plus basse que ladite première couche (59a, 59b, 59c), la concentration en impureté diminuant avec l'augmentation de la profondeur plus lentement que dans ladite première couche.

2. Dispositif à semiconducteurs selon la revendication 1, caractérisé en ce que ladite deuxième couche (57a, 57b, 57c) est formée plus profondément, à partir de la surface dudit corps semiconducteur, qu'au moins une région du deuxième type de conductivité (71) qui est formée dans ladite région d'éléments et qui constitue ledit ou lesdits transistors à effet de champ.

3. Dispositif à semiconducteurs selon les revendications 1 et 2, caractérisé en ce que ladite première couche (59a, 59b, 59c) et ladite deuxième couche (57a, 57b, 57c) sont respectivement formées par des opérations différentes d'implantation ionique.

4. Dispositif à semiconducteurs selon les revendications 1 à 3, caractérisé en ce que la concentration en impureté de ladite première couche (59a, 59b, 59c) est comprise entre environ $8,0 \times 10^{16}$ cm$^{-3}$ et environ $2,2 \times 10^{16}$ cm$^{-3}$ et celle de ladite deuxième couche (57a, 57b, 57c) n'est pas supérieure à environ $2,2 \times 10^{16}$ cm$^{-3}$.

F I G. 1

13

11

N

F I G. 2

13a

13b

13c

11

N

F I G. 3

15a

13a

15b

13b

13c

15c

N+

N+

11

N

F I G. 4

15b

15c

17

15a

N+

N+

11

N

FIG. 5

19a    19b    19c

15a    15b    15c

N⁺    N⁺

N    11

FIG. 6

19a    19b    19c

21a    21b    21c

N⁺    N⁺    N⁺

15a    15b    15c

N    11

FIG. 7

23    21a    19b    19c    25

19a    21b    21c

N⁺    N⁺    N⁺

15a    15b    15c    11

N

# F I G.   8

# F I G.   9

# F I G.   10

FIG. 11

0 127 142

F I G. 12

53

N

51

F I G. 13

55a

55b

55c

53

N

51

F I G. 14

57a

55a

55b

57b

55c

57c

53

N⁺

N⁺

N⁺

51

N

F I G. 15

55a

55b

55c

53c

53a

53b

N⁺

N⁺

N⁺

51

57a

57b

57c

N

# F I G. 16

# F I G. 17

# F I G. 18

# F I G. 19

F I G. 20

F I G. 21

F I G. 22

# F I G. 23